# EUROPEAN PATENT SPECIFICATION

(11) **EP 1 241 508 B1**
(45) Date of publication and mention of the grant of the patent: **04.10.2006**
(21) Application number: 02005580.2
(22) Date of filing: 12.03.2002
(51) Int. Cl.: G02B 26/02, G09F 9/37

(54) **Electrostatically controlled optical microshutter and microshutter matrix with simplified control**
Optischer Mikroverschluss mit elektrostatischem Antrieb und Mikroverschlussmatrix mit vereinfachter Steuerung
Micro-obturateur optique à commande électrostatique et matrice de micro-obturateurs avec commande simplifié

(30) Priority: 16.03.2001 IT TO010251
(43) Date of publication of application: 18.09.2002
(73) Proprietor: C.R.F. Società Consortile per Azioni, 10043 Orbassano (Torino) (IT)
(72) Inventor: Pizzi, Marco, 10100 Torino (IT)
(74) Representative: Notaro, Giancarlo

(56) References cited:
- WO-A-00/73839
- US-A- 5 233 459
- US-B1- 6 239 777

## Description

The present invention relates to electrostatically controlled optical microshutter devices of the type comprising:
a substrate, composed of a lamina of transparent material,
a first electrode composed of a film of transparent conducting material applied to one side of the lamina composing the substrate,
a dielectric layer, also transparent, applied over the film composing the first electrode, and
a movable petal comprising a thin film of conducting material, composing a second electrode, with one end connected to the dielectric layer and movable from a position at rest curled up, in which the passage of light through the substrate is possible, to an uncurled condition over the dielectric layer, in which the passage of light is prohibited through the electrostatic adhesion caused by applying a difference in potential between the first electrode and the second electrode.

A microshutter device of the above type is described and illustrated in the European patent application EP-A-1 008 885 by the same applicant.

In particular the invention relates to a method of operating a matrix of optical microshutters of the type indicated in the preamble of Claim 1. A matrix of this type is known from US 5 233 459 A.

The object of the present invention is to improve the known device by producing a microshutter that can be piloted in a simple and efficient manner and which in particular permits simple and efficient piloting of a matrix composed of a plurality of microshutters identical to one another.

With a view to attaining this object, the subject of the invention is a method having the features of claim 1.

In a practical example of embodiment, the lower surface of the petal adjacent to its end connected to the dielectric layer is in the shape of a step, so that it defines the aforesaid portion of surface spaced from the dielectric surface. Owing to the existence of this spacing, the difference in potential that must be applied to the electrodes in order to cause uncurling of the petal is not merely the difference required to overcome the force of elastic return of the petal towards its curled up condition. Nonetheless, once the petal is uncurled over the surface of the dielectric, the voltage required to keep it in this condition is substantially only the voltage required to overcome the force of elastic return. For example, if uncurling of the petal on the dielectric, which translates into the closed condition of the window controlled by the microshutter, is obtained with the application of a predetermined voltage V, the voltage value required to keep the petal in the uncurled condition may be much lower, for example even less than V/2. Thanks to this characteristic, it is possible to arrange a simplified and efficient control of the microshutter. In fact, there is a voltage value (V) that without doubt causes the microshutter to move to the closed condition. There is also another value (such as V/2) that without doubt keeps the microshutter in the condition in which it is found. In fact, if the microshutter is in the closed condition, the voltage V/2 will keep it in this condition, being sufficient to overcome the force of elastic return of the petal. If the microshutter is in the open condition, that is curled up, the voltage V/2 will keep it in this condition, as it is insufficient to cause the petal to uncurl over the dielectric layer. Thanks to the aforesaid characteristics, it is possible to control the matrix of the microshutters in a simplified manner. In practice, scanning of the state of the microshutter is performed in columns. This means that at all times a specific column, the one in which the state of the microshutters is to be controlled, is supplied with an alternating voltage signal 0-V, while the other columns are supplied with a direct voltage signal V/2, so that the microshutters on these remaining columns without doubt remain in the condition in which they are found. Having established the column on which scanning is performed by application of the alternating voltage signal 0-V, the state of the microshutter arranged on this column will be determined by the signal sent to the corresponding rows. The microshutters of the allocated column found on rows to which an alternating voltage signal 0-V is sent will without doubt move to a open condition, or will remain open if they are already in this condition, as the difference in potential applied to their electrodes will be equivalent to 0. The microshutters of the allocated column which instead are found on rows supplied with an alternating voltage signal outphased by half a period in relation to the previous signal will without doubt move to a closed condition or will remain closed if they are already in this condition, as the difference in potential applied to their electrodes is equivalent to V. Having thus controlled the state of the microshutters on a first column, the system will repeat this procedure on a new column, which in this case will be the only one supplied with an alternating voltage signal 0-V, as the remaining columns are supplied with a direct voltage signal V/2. Once again, the microshutters arranged on the column being scanned will be opened or closed depending on whether the row on which they are found is supplied with an alternating voltage signal 0-V or an alternating voltage signal outphased by half a period compared to the previous signal.

The system is therefore capable of performing simple and efficient scanning of all the microshutters of the matrix. Each microshutter, or each group of microshutters, can correspond to one pixel, for example of a display or other viewing system, which can thus be controlled efficiently to generate an image to be viewed.

Further characteristics and advantages of the invention shall become apparent from the description below with reference to the accompanying drawings, provided purely as a non-limiting example, in which:
figure 1 is a schematic perspective view, enlarged, of a preferred embodiment of a matrix of microshutters according to the invention,
figure 2 is a view on an enlarged scale of a detail of figure 1 indicated with the arrow II,
figure 3 is a sectional view on a further enlarged scale of the detail indicated by the arrow III in figure 2,
figure 4 is a diagram illustrating the hysteresis loop of each microshutter,
figure 5 is a diagram illustrating the basic principle exploited by the system to control the matrix according to the invention, and
figures 6, 7 illustrate two types of voltage signal supplied to the matrix of microshutters according to the invention.

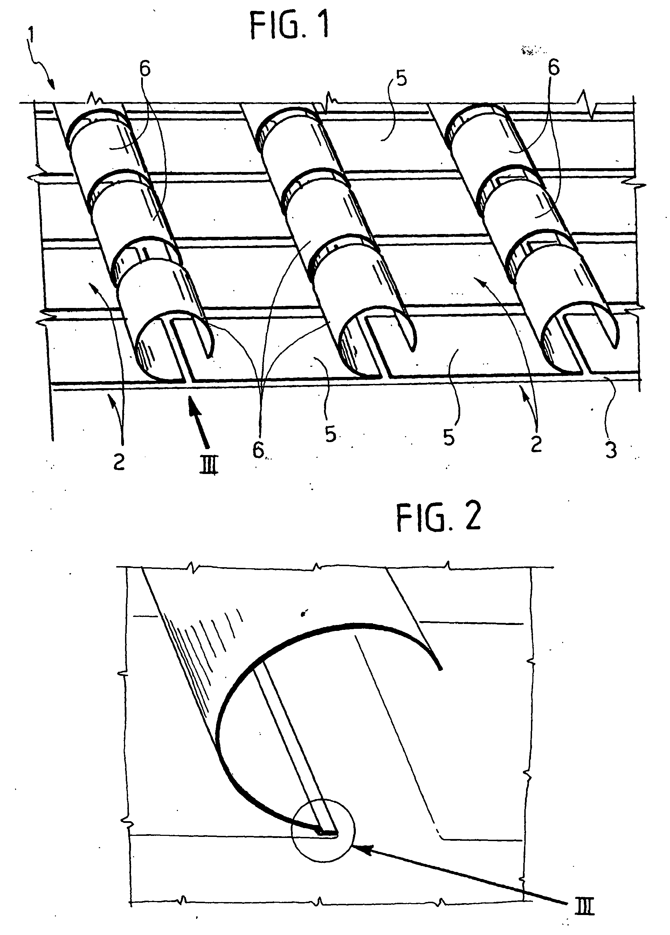

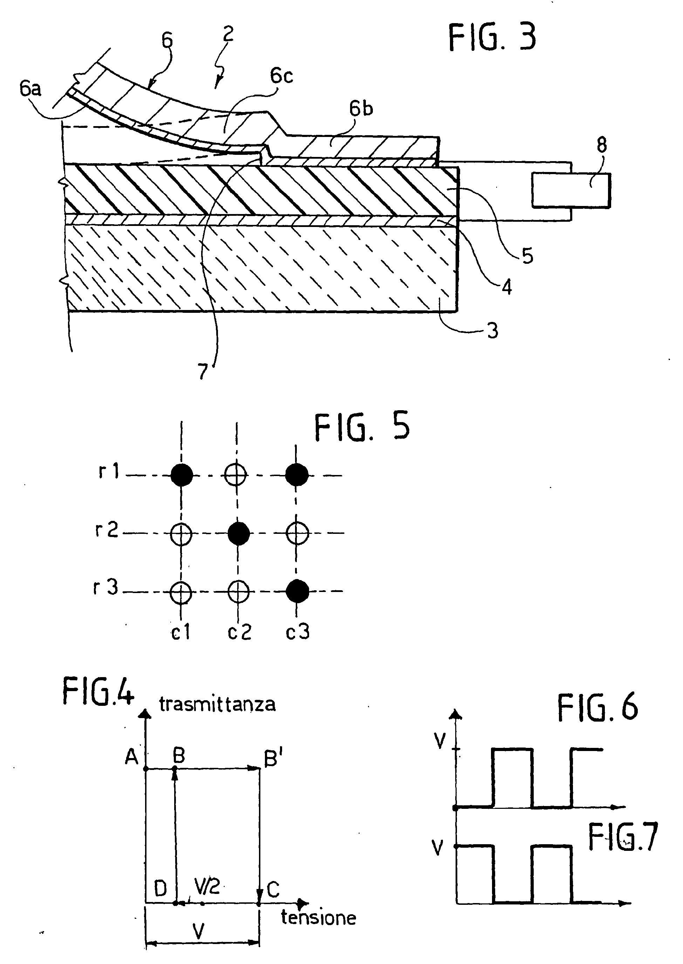

In figure 1, number 1 indicates as a whole a matrix of optical microshutters according to the invention. The figure shows only one part of the matrix, which may for example be used to realize a display of any type, such as a display for an instrument panel of a motor vehicle dashboard, in which each pixel of the display is defined by a microshutter or a group of microshutters. As can be seen in figure 3, each of the microshutters, indicated as a whole with 2, comprises a fixed support including a substrate 3 composed of a lamina in glass or plastic material, transparent to light, a few millimetres or centimetres thick. A layer 4 of conducting material transparent to light (such as ITO, that is indium and tin oxide) a few tens or hundreds of nanometres thick is realized on the surface of the substrate 3 by evaporation, spin-coating, screen-printing or dipping. The conductive layer 4 is subsequently insulated with a layer 5 of dielectric or ferroelectric insulating material transparent to light, the thickness of which can vary from 0.1 micrometres to a few tens of micrometres. This layer can be obtained by screen-printing, spin-coating or dipping.

The reference number 6 indicates the movable part of the device that is composed of a dielectric film a few microns thick, with a metal coated layer 6a on its side facing the dielectric layer 5. The petal 6 is fixed to one end of the dielectric layer of the fixed support so that the metal coated part is in contact with the substrate. The film 6 is an elastic film that in the undeformed condition is curled up as can be seen in figure 1. The dimensions of the film can vary according to the type of microshutter required. By applying an electric voltage between the metal coated layer 6a of the petal 6 and the electrode 4 transparent to light, the petal 6 is uncurled on the surface of the substrate 3, through electrostaticity, preventing the passage of light rays (closed condition of the microshutter).

As can be seen in figure 3, the metal-coated surface of the petal 6 has a step 7 adjacent to the end 6b of the petal that is connected to the fixed support, so that the portion 6c of the petal adjacent to the end 6b has its metal coated surface 6a facing the dielectric layer 5 slightly spaced from the latter. Due to this characteristic, the electric voltage that must be applied between the electrodes 6a to obtain adhesion through electrostaticity of the petal 6 to the surface of the dielectric 5 has a value V that is greater than the value necessary simply to overcome the force of elastic reaction of the petal which tends to return the petal towards the curled up configuration. In figure 3, the uncurled position of the portion 6c over the dielectric layer is shown with a dashed line. Due to the spacing caused by the step 7, as already mentioned, this condition is obtained by applying a voltage value V greater than the value required to overcome the force of elastic reaction of the petal. For the same reason, once the petal 6 is in the uncurled condition over the dielectric layer 5, it can be kept adhering to the petal by applying a much lower voltage than the value V required to cause the microshutter to close, such as a value below the value V/2. This situation is represented in the diagram of figure 4, which shows the variation in transmittance through the transparent support when the voltage applied between the electrodes of a specific microshutter is varied. In the diagram in figure 4, point A corresponds to the microshutter in an open condition. In this condition, no voltage is applied to the electrodes of the microshutter, and the petal 6 is curled up, so that transmittance through the transparent fixed support is maximum. When it is in this condition, the microshutter is closed taking the voltage to a value V (point B of the diagram). If the step 7 were not provided, closing of the microshutter would be obtained at a point B^{I}, that is at a much lower voltage value. However, due to the step 7, it is only upon reaching the voltage value V that the microshutter closes, and therefore transmittance drops suddenly to 0 (point C in the diagram). At this point, even if the electric voltage value is lowered, the petal remains adherent, until reaching point D corresponding to the voltage value required to overcome the force of electric reaction of the petal. Below this value the force of elastic reaction of the petal prevails, so that the petal curls up again and transmittance returns to maximum (point B^{I}). The microshutter then performs a hysteresis loop which can be exploited to realize a simplified and efficient control of the matrix. In fact, for the reasons set forth above, by applying a voltage value V to the electrodes of the microshutter, the microshutter will without doubt close if the microshutter was previously open or it will remain closed if it was already in a closed condition. Instead, by applying a lower voltage value, such as a value established for convenience equal to V/2, the microshutter will without doubt remain in the same state, that is it will remain open if it is already open (as the voltage V/2 is not sufficient to close it) or remain closed if it is already in a closed condition, as the voltage V/2 is in any case sufficient to keep the petal uncurled.

In the preferred embodiment, this is obtained as follows. Purely as an example figure 5 shows a matrix according to the invention composed of nine microshutters arranged in three rows r1, r2, r3 and three columns c1, c2, c3. Figure 5 shows purely as an example a specific condition of the matrix, in which some microshutters are in the closed condition (black circles) and some microshutters are in the open condition (white circles).

Associated with the matrix according to the invention are means 8 (shown schematically in figure 3) to apply a difference in potential between the two electrodes of each microshutter. The means 8 are suitable to control the situation of the matrix in figure 5 at all times by performing scanning, for example according to column. For this purpose, they supply a common voltage signal to the first electrode 4 of all the microshutters found on one same column c, while in the same way they send a common voltage signal to the second electrodes 6a of all the microshutters found on one same row r.

Still as regards the specific embodiment according to the invention, a direct voltage signal equal to V/2 is sent to each column (V being the predetermined voltage value shown in figure 4 required to cause closing of the microshutter when it is in the open condition). This direct voltage signal V/2 is sent to the first electrode 4 of all the microshutters of one same column as long as the state of these microshutters must not be modified. However, when the state of one or more of the microshutters on one same column must be modified, the first electrode 4 of the microshutters found on this column is supplied with a square wave alternating voltage signal, oscillating between the values 0 and V, of the type shown in fig. 6.

Moreover, the second electrode 6a of the microshutters found in one same row is supplied with a square wave alternating voltage signal, variable from 0 to V (fig. 6) each time one of more of the microshutters in the row must be taken to the open condition, while the signal supplied to the row is a square wave alternating voltage signal outphased by half a period in relation to the previous one (fig. 7) when one or more of the microshutters in the row must be taken to the closed condition.

As already mentioned, scanning of the matrix is performed according to column. Therefore, for example, if we wish to start to control the state of the microshutters in the column c1, the signal supplied on this column will be a square wave alternating voltage signal variable from 0 to V (fig. 6), while the signals supplied to the columns c2 and c3 will be direct voltage signals equal to V/2. In this phase, if we wish to take the microshutter r1-c1 to the closed condition, as shown, it will be necessary to supply the row r1 with an alternating voltage signal outphased by half a period (fig. 7), while the rows r2 and r3 will be supplied with an alternating voltage signal 0-V (fig. 6), so as to open the microshutters r2-c1 and r3-cl. In fact, at the microshutter r1-c1, the electrode 4 is supplied with an alternating voltage signal o-V (figure 6), while the electrode 6a is sent an equal and opposite signal (figure 7). Consequently, a difference in potential equal to V is established between the two electrodes of the microshutter r1-c1, so that the microshutter closes (if it was open) or remains closed, if it was already closed. Instead, at the microshutters r2-c1 and r3c1, the two electrodes 4 and 6a are supplied with the same alternating voltage signal (figure 6), that the difference in potential between the electrodes of these microshutters is 0 and they therefore open (if they were closed) or remain open (if they were already open).

Finally, during the phase described above, the microshutters found on the columns c2 and c3 instead remain in their current situation. In fact, as a direct voltage signal equal to V/2 is supplied on the columns , the difference in potential applied to the electrodes of each of these microshutters is equal to V/2 both when these are in a row supplied with the signal in figure 6, and when they are in a row supplied with the signal in figure 7. The voltage V/2 is sufficient to keep these shutters closed when they are closed, while it is not sufficient to close them, if they are open. Therefore, each of the microshutters of the columns c2, c3, in this phase, remains in its current condition.

Scanning is thus performed on the column c2. In this phase, the signal supplied on the column c2 becomes a square wave alternating voltage signal oscillating between 0 and V (the signal in figure 6), while the direct voltage signal V/2 is supplied on the columns c1 and c3. If we wish to obtain the situation shown in figure 5 for the microshutters found on the column c2, the rows r1 and r3 are each supplied with the signal in figure 6, and the row r2 with the signal in figure 7. Analogously, during scanning of the third column c3, only this column is supplied with the signal in figure 6, while the other columns are supplied with the direct voltage signal equal to V/2. In this phase the rows r1 and r3 are supplied with the alternating voltage signal outphased by half a period (figure 7), while the row r2 is supplied with the square wave alternating voltage signal shown in figure 6.

In conclusion, the arrangement of the step 7 on each microshutter makes it possible to obtain a voltage value V which without doubt causes closing of the microshutter, and a lower value (here for convenience chosen equal to V/2) that without doubt keeps the microshutter in the current condition. It is therefore possible to realize simplified and efficient controls of the state of the matrix, according to the example described above.

## Claims

1. Method of operating a matrix of electrostatically controlled optical microshutters (2), said optical microshutters (2) comprising:
a substrate (3) composed of a lamina of transparent material,
a first electrode (4) composed of a film of transparent conducting material applied to one side of the lamina forming the substrate (3),
a dielectric layer (5), also transparent, applied over the film composing the first electrode (4), and
a movable petal (6) comprising a thin film (6a) of conducting material, composing a second electrode, with one end connected to the dielectric layer (5) and movable from a position at rest, in which light can pass through the substrate (3), to an uncurled condition over the dielectric layer, in which the passage of light is prohibited through the electrostatic adhesion caused by applying a difference in potential between the first electrode (4) and the second electrode (6a),
wherein a portion of the petal (6c) immediately adjacent to its end that is connected to the dielectric layer (5) has one surface facing the dielectric layer that is spaced from this, so that in order to cause uncurling of the petal (6) on the dielectric layer (5), it is necessary to apply a difference in potential between the two electrodes (4, 6a) of a predetermined value V, above the value required to overcome the elastic force of the petal that pulls the petal towards its condition at rest, while in order to keep the petal in this uncurled condition it is sufficient to apply a difference in potential below the aforesaid predetermined value V,
wherein said plurality of microshutters are arranged in rows (r) and columns (c), and.
wherein associated with this matrix are means to apply an electric voltage between the electrodes (4, 6a) of all the microshutters (2) of the matrix, said means being suitable to send a common voltage signal to a first electrode (6a) of all the microshutters of each row (r), and a common voltage signal to the other electrode (4) of all the microshutters of each column (c),
said method being **characterized in that**:
a direct voltage signal equal to V/2 is sent to each column (c) as long as the state of the shutters of the column must not be modified, and a first square wave alternating voltage signal, oscillating between the values 0 and V, is sent to each column, each time the state of at least one of the shutters in the column must be modified, and
a second square wave alternating voltage signal, oscillating between 0 and and in phase with the first signal, is sent to each row each time at least one microshutter of the row is to be taken to or kept in an open condition, and a third square wave alternating voltage signal, oscillating between O and V and outphased by half a period in relation to the first signal is sent to each row each time at least one microshutter of the row is to be taken to or kept in a closed condition.

2. Method as claimed in claim 1, **characterized in that** the lower surface of the petal (6) adjacent to its end connected to the dielectric layer (5) is in the shape of a step (7), so that it defines the aforesaid portion of surface spaced from the surface of the dielectric.

## Patentansprüche

1. Verfahren zum Betätigen einer Matrix von elektrostatisch gesteuerten optischen Mikroverschlüssen (2), wobei die optischen Mikroverschlüsse (2) folgendes umfassen:
ein Substrat (3), das aus einem Blättchen aus transparentem Material besteht,
eine erste Elektrode (4), die aus einer Folie aus transparentem leitendem Material besteht, die auf einer Seite des das Substrat (3) bildenden Blättchens aufgebracht ist,
eine ebenfalls transparente Dielektrikumschicht (5), die über der die erste Elektrode (4) bildenden Folie aufgebracht ist, und
eine bewegliche Lamelle (6), die einen dünnen Film (6a) aus leitendem Material umfaßt, das eine zweite Elektrode bildet, wobei ein Ende mit der Dielektrikumschicht (5) verbunden ist und von einer Ruheposition, in der Licht durch das Substrat (3) hindurchtreten kann, in einen entrollten Zustand über der Dielektrikumschicht bewegt werden kann, in der der Durchtritt von Licht durch die elektrostatische Haftung verhindert wird, die verursacht wird durch Anlegen einer Potentialdifferenz zwischen der ersten Elektrode (4) und der zweiten Elektrode (6a),
wobei ein Abschnitt der Lamelle (6c) unmittelbar neben ihrem Ende, das mit der Dielektrikumschicht (5) verbunden ist, eine der Dielektrikumschicht zugewandte Oberfläche aufweist, die davon beabstandet ist, sodaß, um ein Entrollen der Lamelle (6) auf der Dielektrikumschicht (5) zu verursachen, es erforderlich ist, eine Potentialdifferenz zwischen den beiden Elektroden (4, 6a) mit einem vorbestimmten Wert V über dem Wert anzulegen, der erforderlich ist, um die elastische Kraft der Lamelle zu überwinden, die die Lamelle in Richtung ihres Ruhezustands zieht, während es, um die Lamelle in diesem entrollten Zustand zu halten, ausreicht, eine Potentialdifferenz unterhalb des oben erwähnten vorbestimmten Wertes V anzulegen,
wobei die mehreren Mikroverschlüsse in Reihen (r) und Spalten (c) angeordnet sind und
wobei mit dieser Matrix Mittel assoziiert sind zum Anlegen einer elektrischen Spannung zwischen den Elektroden (4, 6a) aller Mikroverschlüsse (2) der Matrix, wobei sich die Mittel dafür eignen, ein gemeinsames Spannungssignal an eine erste Elektrode (6a) aller Mikroverschlüsse jeder Reihe (r) und ein gemeinsames Spannungssignal an die andere Elektrode (4) aller Mikroverschlüsse jeder Spalte (c) zu senden,
wobei das Verfahren **dadurch gekennzeichnet ist, daß**:
ein Gleichspannungssignal gleich V/2 zu jeder Spalte (c) solange gesendet wird, wie der Zustand der Verschlüsse der Spalte nicht modifiziert werden muß, und ein erstes Rechteckwellenwechselspannungssignal, das zwischen den Werten 0 und V oszilliert, zu jeder Spalte immer dann gesendet wird, wenn der Zustand mindestens eines der Mikroverschlüsse in der Spalte modifiziert werden muß, und
ein zweites Rechteckwellenwechselspannungssignal, das zwischen den Werten 0 und V und in Phase mit dem ersten Signal oszilliert, immer dann zu jeder Zeile gesendet wird, wenn mindestens ein Mikroverschluß der Reihe in einen offenen Zustand überführt oder darin gehalten werden soll, und ein drittes Rechteckwellenwechselspannungssignal, das zwischen 0 und V oszilliert und um eine halbe Periode relativ zu dem ersten Signal außer Phase ist, immer dann zu jeder Reihe gesendet wird, wenn mindestens ein Mikroverschluß der Reihe in einen geschlossenen Zustand überführt oder darin gehalten werden soll.

2. Verfahren nach Anspruch 1, **dadurch gekennzeichnet, daß** die untere Oberfläche der Lamelle (6) neben ihrem mit der Dielektrikumschicht (5) verbundenen Ende in Gestalt einer Stufe (7) vorliegt, sodaß sie den oben erwähnten Oberflächenabschnitt definiert, der von der Oberfläche des Dielektrikums beabstandet ist.

## Revendications

1. Procédé destiné à faire fonctionner une matrice de micro-obturateurs optiques (2) commandés de manière électrostatique, lesdits micro-obturateurs optiques (2) comprenant :
un substrat (3) d'une strate de matériau transparent,
une première électrode (4) composée d'un film de matériau conducteur transparent appliqué sur un côté de la strate formant le substrat (3),
une couche diélectrique (5), également transparente, appliquée sur le film composant la première électrode (4), et
un pétale mobile (6) comprenant un film mince (6a) de matériau conducteur, composant une deuxième électrode, avec une extrémité reliée à la couche diélectrique (5) et mobile d'une position au repos, dans laquelle la lumière peut passer à travers le substrat (3) à un état déroulé sur la couche diélectrique, dans lequel le passage de la lumière est empêché par l'intermédiaire de l'adhérence électrostatique provoquée par l'application d'une différence de potentiel entre la première électrode (4) et la deuxième électrode (6a),
dans lequel une partie du pétale (6c) immédiatement adjacente par rapport à son extrémité qui est reliée à la couche diélectrique (5) a une surface faisant face à la couche diélectrique qui est espacée de celle-ci, de sorte que pour entraîner le déroulement du pétale (6) sur la couche diélectrique (5), il soit nécessaire d'appliquer une différence de potentiel entre les deux électrodes (4, 6a) d'une valeur prédéterminée V, au-dessus de la valeur nécessaire pour surmonter la force élastique du pétale qui tire le pétale vers son état au repos, alors que pour maintenir le pétale dans cet état déroulé il suffit d'appliquer une différence de potentiel au-dessous de la valeur prédéterminée susdite V,
dans lequel ladite pluralité de micro-obturateurs sont agencés en rangées (r) et en colonnes (c), et,
dans lequel on associe à cette matrice des moyens destinés à appliquer une tension électrique entre les électrodes (4, 6a) de l'ensemble de micro-obturateurs (2) de la matrice, lesdits moyens étant appropriés pour envoyer un signal de tension commune à une première électrode (6a) de l'ensemble de micro-obturateur de chaque rangée (r), et un signal de tension commune à l'autre électrode (4) de l'ensemble des micro-obturateurs de chaque colonne (c),
ledit procédé étant **caractérisé en ce que** :
un signal de tension continue égal à V/2 est envoyé à chaque colonne (c) aussi longtemps que l'état des obturateurs de la colonne ne doit pas être modifié, et un premier signal de tension alternative à ondes carrées, oscillant entre les valeurs 0 et V, est envoyé à chaque colonne, chaque fois que l'état d'au moins un des obturateurs dans la colonne doit être modifié, et
un deuxième signal de tension alternative à onde carrée, oscillant entre 0 et V et en phase avec le premier signal, est envoyé à chaque rangée chaque fois qu'au moins un micro-obturateur de la rangée doit être mis ou maintenu dans un état ouvert, et un troisième signal de tension alternative à onde carrée oscillant entre 0 et V déphasé d'une demi-période par rapport au premier signal, est envoyé à chaque rangée chaque fois qu'au moins un micro-obturateur de la rangée doit être mis ou maintenu dans un état fermé.

2. Procédé selon la revendication 1, **caractérisé en ce que** la surface inférieure du pétale (6) adjacente par rapport à son extrémité reliée à la couche diélectrique (5) est sous la forme d'un gradin (7), de sorte qu'elle définisse la partie de surface susdite espacée de la surface de la couche diélectrique.
